# FASCICULE DE BREVET EUROPEEN

(11) **EP 0 526 312 B1**
(45) Date de publication et mention de la délivrance du brevet: **15.03.1995**
(21) Numéro de dépôt: 92402130.6
(22) Date de dépôt: 23.07.1992
(51) Int. Cl.: C30B 23/06

(54) **Procédé et cellule d'effusion pour la formation de jets moléculaires**
Verfahren und Effusionszelle zur Erzeugung von Molekularstrahlen
Process and effusion cell for forming molecular beams

(30) Priorité: 01.08.1991 FR 9109812
(43) Date de publication de la demande: 03.02.1993
(73) Titulaire: ALCATEL ALSTHOM COMPAGNIE GENERALE D'ELECTRICITE, 75382 Paris Cédex 08 (FR)
(72) Inventeur: Goldstein, Léon, F-92370 Chaville (FR); Vergnaud, René, F-91770 St Vrain (FR); Chardon, Jean-Pierre, F-94320 Thiais (FR)
(74) Mandataire: Bourely, Paul

(56) Documents cités:
- FR-A- 2 572 099
- FR-A- 2 598 721
- GB-A- 2 080 271
- US-A- 5 034 604
- JOURNAL OF VACUUM SCIENCE AND TECHNOLOGY: PART B. vol. 8, no. 2, Mars 1990, NEW YORK US pages 168 - 171 R.N.SACKS ET AL 'Evaluation of a new high capacity,all-tantalum molecular-beam-epitaxy arsenic cracker furnace'
- JOURNAL OF VACUUM SCIENCE AND TECHNOLOGY: PART B. vol. 6, no. 6, Novembre 1988, NEW YORK US pages 1667 - 1670 MATTORD ET AL 'baffle - free refractory dimer arsenic source for molecular-beam epitaxy'
- JOURNAL OF VACUUM SCIENCE AND TECHNOLOGY: PART B. vol. 3, no. 3, Mai 1985, NEW YORK US pages 823 - 829 D.HUET ET AL 'molecular beam epitaxy of In0.53Ga0.47As and InP on InP by using cracker cells'

## Description

La présente invention concerne la formation de jets moléculaires notamment celle de jets moléculaires de phosphore et d'arsenic pour la croissance épitaxiale de composants semiconducteurs tels que des lasers.

Le développement important de l'épitaxie par jets moléculaires des composés III- V a conduit à la mise au point de nouvelles cellules d'effusion pour l'arsenic et le phosphore. Ces cellules permettent l'obtention de flux d'arsenic et de phosphore nécessaires à la croissance épitaxiale de matériaux tels que GaAs, GaAlAs, InP, GaP, GaInP...

Au cours de ces dernières années, les améliorations étudiées par les constructeurs RIBER, VG, INTEVAC (ex VARIAN) visaient des objectifs :
a) Réalisation de cellules de grande capacité permettant d'utiliser des charges d'arsenic et de phosphore de 300 g environ. Cette amélioration permet d'augmenter considérablement le temps d'utilisation d'une enceinte de croissance épitaxiale entre deux ouvertures de celle-ci.
b) Mise au point de cellules d'effusion comportant une tête de craquage à haute température (900°C) pour le craquage des espèces moléculaires As₄, P₄, en As₂, P₂.

Des cellules connues comportent typiquement deux zones portées à des températures différentes :
- Une chambre de sublimation à basse température (environ 300°C) où l'arsenic ou le phosphore solide est sublimé en formant des tetramères suivant la réaction :

   Asₛₒₗ → As₄

   Psol → P₄
- une tête de craquage où on réalise l'opération de craquage à environ 900°C.

   As₄ → As₂

   P₄ → P₂

L'utilisation des molécules dimères, P₂ en particulier, permet d'améliorer considérablement les conditions de croissance des matériaux à base de phosphore en augmentant le coefficent de collage du phosphore. Ceci se traduit par une réduction très significative de la consommation de phosphore (facteur 10).

Les cellules actuellement mises au point par les constructeurs intègrent ces deux améliorations importantes. Mais il reste difficile de contrôler à 1 % près les débits d'As₂ et P₂ pour la croissance d'alliages de type GaInAsP, ou d'obtenir des variations rapides de deux débits distincts d'As₂ et P₂ alors que de telles variations sont nécessaires pour la réalisation de certaines hétérostructures ou d'alliages à base de GaInAsP.
A l'heure actuelle les techniques dites "EJMSG" ou "MOMBE" qui utilisent les hydrures gazeux arsine et phosphine permettent de pallier les inconvénients décrits précédemment. Mais il est nécessaire d'utiliser pour cela les produits hautement toxiques que sont ces hydrures et de prendre alors des précautions coûteuses.

La présente invention a notamment pour but de réaliser de manière simple une cellule permettant de commander avec précision et rapidité le débit de jets moléculaires et ceci sans utilisation de produits dangereux.

Dans ce but elle a notamment pour objet un procédé d'effusion pour la formation de jets moléculaires, procédé selon lequel des molécules primaires sont formées par sublimation dans une chambre de sublimation puis transférées avec un débit de transfert dans une tête de craquage à température supérieure pour y être transformée en molécules secondaires plus légères et former des jets moléculaires, ce procédé étant caractérisé par le fait que le débit de transfert est commandé par réglage d'un débit vecteur effectif qui est celui d'un gaz vecteur introduit dans la chambre de sublimation. En outre elle a pour objet une celle d'effusion pour la formation de jets moléculaires comme revendiquée dans le revendication 3.

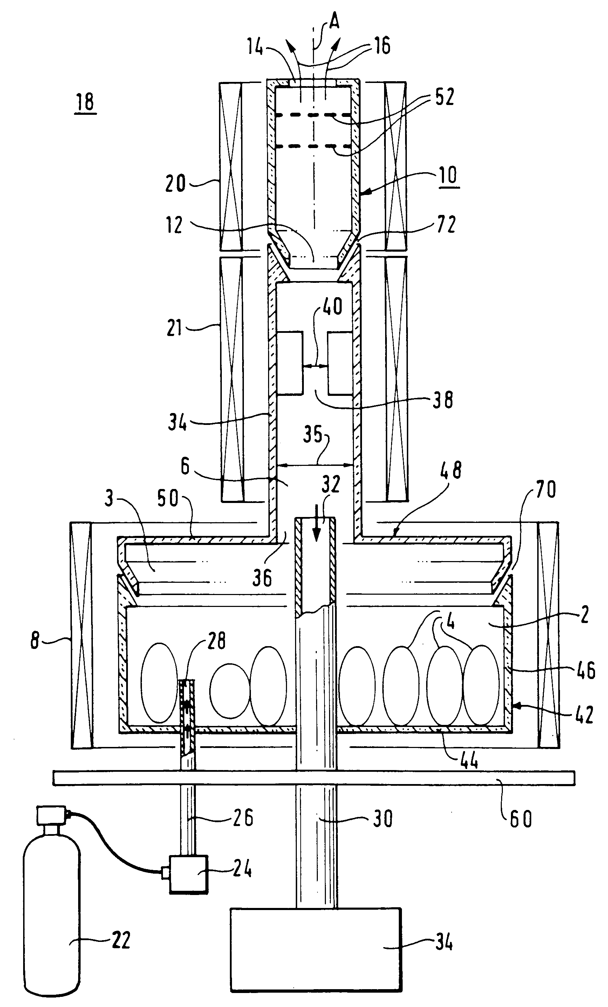

A l'aide de la figure schématique ci-jointe, on va décrire plus particulièrement ci-après, à titre d'exemple non limitatif, comment la présente invention peut être mise en oeuvre. Il doit être compris que les éléments mentionnés peuvent être remplacés par d'autres éléments assurant les mêmes fonctions techniques.

La figure représente une vue en coupe d'une cellule selon cette invention.

Cette cellule présente une forme générale de révolution autour d'un axe A. Elle est portée par une bride 60 apte à être insérée de manière étanche dans la paroi d'une enceinte de croissance épitaxiale 18 qui est évacuée et maintenue sous vide.

Certains des éléments essentiels de cette cellule sont connus quant à leurs fonctions et à leurs particularités indiquées ci-après :
- une chambre de sublimation 2 présentant un espace interne 3 pour contenir une charge 4 à l'état solide d'un corps chimique pouvant constituer deux espèces moléculaires gazeuses constituées l'une de molécules primaires, l'autre de molécules secondaires qui sont plus légères que ces molécules primaires et qui doivent former un jet moléculaire présentant un débit massique souhaité, cette chambre présentant une sortie 6 pour permettre à des molécules gazeuses de ce corps de sortir de cette chambre,
- un moyen de chauffage de sublimation 8 fournissant une puissance thermique de sublimation pour porter cette chambre à une température de sublimation provoquant la sublimation dudit corps chimique sous la forme desdites molécules primaires avec un débit massique au moins égal en moyenne audit débit massique souhaité, de manière que ces molécules primaires sortent de cette chambre avec un débit massique réglable constituant un débit de transfert,
- une tête de craquage creuse 10 présentant une entrée 12 pour recevoir lesdites molécules primaires sortant de la chambre de sublimation 2, et une sortie 14 pour permettre à des molécules gazeuses de sortir de cette tête, vers l'enceinte 18,
- et un moyen de chauffage de craquage 20 pour porter cette tête de craquage 10 à une température de craquage qui est supérieure à ladite température de sublimation et qui est choisie pour former dans cette tête lesdites molécules secondaires à partir desdites molécules primaires, de manière que ces molécules secondaires sortent de cette chambre en formant ledit jet moléculaire 16 avec un débit massique sensiblement égal audit débit de transfert.

Ledit corps chimique est typiquement le phosphore ou l'arsenic, lesdites molécules primaires et secondaires étant des tétramères et des dimères respectivement, lesdites températures de sublimation et de craquage étant respectivement voisines de 300°C et de 900°C.

Conformément à la présente invention cette cellule comporte en outre :
- une source de gaz vecteur 22 pour fournir un gaz vecteur propre à entraîner lesdites molécules primaires sans réagir avec ledit corps chimique,
- un moyen de réglage de débit 24 alimenté par cette source pour transmettre un débit réglable de ce gaz vecteur, ce débit constituant un débit vecteur d'entrée,
- un conduit d'amenée de gaz vecteur 26 présentant une sortie 28 dans ladite chambre de sublimation pour y introduire ce débit vecteur d'entrée,
- et un passage de transfert étroit 38 entre cette chambre de sublimation 2 et ladite tête de craquage 10 pour maintenir une pression gazeuse plus élevée dans cette chambre que dans cette tête. Ce passage est traversé par le gaz vecteur avec un débit vecteur effectif constitué à partir du débit vecteur d'entrée. Selon l'invention un réglage de ce débit vecteur effectif assure un réglage du débit de transfert et, plus particulièrement, une variation rapide et connue de ce débit vecteur effectif entraîne une variation rapide et connue de ce débit de transfert.

De préférence cette cellule comporte en outre :
- un tube d'aspiration 30 présentant une entrée 32 dans la chambre de sublimation,
- et des moyens d'aspiration 34 pour aspirer, par l'intermédiaire de ce tube d'aspiration, un débit réglable des gaz présents dans cette chambre, ce débit constituant un débit d'aspiration. Le débit vecteur effectif est alors sensiblement égal à la différence entre le débit vecteur d'entrée et ce débit d'aspiration, et un réglage de ce débit d'aspiration contribue au réglage dudit débit de transfert. Plus spécifiquement un tel réglage permet d'obtenir des variations particulièrement rapides du débit de transfert, et notamment une annulation brusque de ce débit grâce à une aspiration rapide à grand débit. Une telle annulation rapide peut notamment être nécessaire à la réalisation d'une transition de composition abrupte dans un composant semiconducteur réalisé par croissance épitaxiale par jets moléculaires. Pour permettre de réaliser cette aspiration rapide, le tube d'aspiration présente une section de passage importante et les moyens d'aspiration comportent un volume mis préalablement sous vide pour recevoir les gaz aspirés. De plus l'entrée du tube d'aspiration est voisine du passage de transfert étroit de manière que l'effet de cette aspiration apparaisse d'abord à l'entrée de ce passage.

Plus précisément la sortie 6 de la chambre de sublimation 2 est munie d'un tube de transfert 34 présentant une section de passage 35 supérieure à quatre fois celle 40 dudit passage de transfert étroit 38. Ce tube a une entrée 36 ouverte sur l'espace interne 3 de cette chambre, et une sortie constituée par le passage de transfert étroit 38. L'entrée du tube d'aspiration 30 est située dans ce tube de transfert.

De préférence des dispositions sont prises pour que le gaz vecteur balaie l'espace interne 3 de la chambre 2 et y soit sensiblement saturé, au moins au voisinage de la sortie 6 de cette chambre, par lesdites molécules primaires, c'est-à-dire pour que ces molécules créent dans ce gaz une pression partielle sensiblement égale à leur pression de vapeur saturante en présence de ladite charge 4. Ces dispositions concernent d'une part le choix de la puissance thermique de sublimation, d'autre part les positions de la sortie 38 du conduit 26 d'amenée de gaz vecteur dans la chambre de sublimation 2 et de la sortie 6 de cette chambre.

De préférence la cellule comporte trois pièces raccordées entre elles en série de manière amovible, à savoir :
- une pièce de base 42 constituant au moins un fond 44 et une paroi latérale 46 de la chambre de sublimation,
- une pièce intermédiaire 48 constituant au moins partiellement un couvercle 50 de la chambre de sublimation et le tube de transfert 34,
- et une pièce terminale 10 constituant au moins la tête de craquage. Ledit passage de transfert étroit est alors formé par l'une au moins des pièces intermédiaire 48 et terminale 10, à savoir, dans l'exemple décrit, par le tube de transfert qui fait partie de la pièce intermédiaire.

Les pièces de base 42 et intermédiaire 48 sont constituées de quartz. La pièce terminale 10 est constituée de nitrure de bore et présente des chicanes internes 52 pour thermaliser les molécules primaires et secondaires. Des rodages 70 et 72 de type classiques permettent le raccordement de ces pièces avec un degré d'étanchéité suffisant.

Plus particulièrement la chambre de sublimation 2 consiste en un réservoir cylindrique de quartz d'une capacité typique de 300 g d'As ou P. Deux transitions verre-métal sur les deux tubes 26 et 30 permettent la fixation de la cellule sur la bride ultravide 60. L'introduction du gaz vecteur peut être obtenue par un débimètre massique avec une précision de 0.5 %.
La commande des moyens d'aspiration 34 permet, par l'intermédiaire du tube d'aspiration central 30, de régler la pression du mélange gazeux dans la chambre de sublimation avec une précision de l'ordre de 0.2 %. Les variations rapides de la pression dans la chambre 2 permettent de réaliser les transitions de compositions nécessaires pour les épitaxies.
Un four dit à basse température constitue le moyen de chauffage de sublimation 8. Il est fixé sur la bride ultravide 60.

Le tube de transfert 34 est fixé sur la pièce de base 42 par l'intermédiaire d'un rôdage 70. L'ensemble étant situé dans l'enceinte sous ultravide 18, il n'est pas nécessaire d'obtenir une parfaite étanchéité à ce niveau. Ce tube est muni d'une partie de type capillaire qui constitue ledit passage de transfert étroit 38 et maintient une différence de pression importante entre la chambre de sublimation et la tête de craquage. De cette chambre à cette tête la pression passe typiquement de 1330 Pa à 1,33 ou 1,33.10⁻² Pa.

Le tube de transfert est porté à une température de l'ordre de 400°C à l'aide d'un four à deux zones 21 et 20 entourant ce tube et la tête de craquage 10. Ce four est fixé sur une bride ultravide "à demeure" non représentée .

La tête de craquage 10 est constitué d'un ensemble en nitrure de bore muni de chicanes 52. Elle est portée à 900°C de manière à assurer la conversion As₄→2As₂ ou P₄→2P₂.

La conception des chicanes doit permettre une bonne thermalisation du gaz et une faible perte de charge du mélange.

La présente invention permet d'obtenir les avantages suivants :
- le contrôle au 1 % des débits d'As₂ et P₂,
- l'obtention de variations rapides de ces débits,
- la suppression des gaz hydrures toxiques tels que l'arsine et la phosphine. Ce dernier avantage revêt une importance toute particulière car les précautions de sécurité peuvent être considérablement allégées voire supprimées. Ceci permet aux utilisateurs d'effectuer des expériences similaires à celles nécessitant les gaz hydrures sur des sites où ces gaz sont proscrits. De même l'investissement en dispositifs de sécurité est allégé voire supprimé.

Par ailleurs la mise en oeuvre d'une telle cellule simplifie les installations puisqu'on supprime les modules de stockage et de régulation des hydrures.

## Revendications

1. Procédé d'effusion pour la formation de jets moléculaires, procédé selon lequel des molécules primaires sont formées par sublimation dans une chambre de sublimation (2) puis transférées avec un débit de transfert dans une tête de craquage (10) à température supérieure pour y être transformée en molécules secondaires plus légères et former des jets moléculaires (16), ce procédé étant caractérisé par le fait que le débit de transfert est réglé par réglage d'un débit vecteur effectif qui est celui d'un gaz vecteur introduit dans la chambre de sublimation.

2. Procédé selon la revendication 1, dans lequel lesdites molécules primaires et secondaires sont respectivement des tétramères (P₄, As₄) et des dimères (P₂, As₂) de phosphore (P) ou d'arsenic (As), ledit gaz vecteur étant de l'hydrogène (H2), de l'argon (Ar) ou de l'azote (N2), lesdites chambre de sublimation et tête de craquage étant respectivement portées à des températures voisines de 300°C et 900°C, lesdits jets moléculaires étant injectés dans une enceinte de croissance épitaxiale (18).

3. Cellule d'effusion pour la formation de jets moléculaires, cette cellule comportant :
- une chambre de sublimation (2) présentant un espace interne (3) pour contenir une charge (4) à l'état solide d'un corps chimique pouvant constituer deux espèces moléculaires gazeuses constituées l'une de molécules primaires, l'autre de molécules secondaires qui sont plus légères que ces molécules primaires et qui doivent former un jet moléculaire présentant un débit massique souhaité, cette chambre présentant une sortie (6) pour permettre à des molécules gazeuses de ce corps de sortir de cette chambre,
- un moyen de chauffage de sublimation (8) fournissant une puissance thermique de sublimation pour porter cette chambre à une température de sublimation provoquant la sublimation dudit corps chimique sous la forme desdites molécules primaires avec un débit massique au moins égal en moyenne audit débit massique souhaité, de manière que ces molécules primaires sortent de cette chambre avec un débit massique réglable constituant un débit de transfert,
- une tête de craquage (10) creuse présentant une entrée (12) pour recevoir lesdites molécules primaires sortant de la chambre de sublimation (2), et une sortie pour permettre à des molécules gazeuses de sortir de cette tête vers une enceinte sous vide (18),
- et un moyen de chauffage de craquage (20) pour porter cette tête de craquage (10) à une température de craquage qui est supérieure à ladite température de sublimation et qui est choisie pour former dans cette tête lesdites molécules secondaires à partir desdites molécules primaires, de manière que ces molécules secondaires sortent de cette chambre en formant ledit jet moléculaire (16) avec un débit massique sensiblement égal audit débit de transfert,
- cette cellule étant caractérisée par le fait qu'elle comporte en outre :
- une source de gaz vecteur (22) pour fournir un gaz vecteur propre à entraîner lesdites molécules primaires sans réagir avec ledit corps chimique,
- un conduit d'amenée de gaz vecteur (26) présentant une sortie (28) dans ladite chambre de sublimation (2) pour y introduire ce gaz avec un débit vecteur d'entrée,
- et un passage de transfert étroit (38) entre cette chambre de sublimation (2) et ladite tête de craquage (10) pour maintenir une pression gazeuse plus élevée dans cette chambre que dans cette tête,
de manière qu'un débit vecteur effectif dudit gaz vecteur soit constitué à partir de ce débit vecteur d'entrée et traverse ce passage de transfert et qu'un réglage de ce débit vecteur effectif assure un réglage dudit débit de transfert.

4. Cellule selon la revendication 3 caractérisée par le fait qu'elle comporte en outre :
- un tube d'aspiration (30) présentant une entrée (32) dans la chambre de sublimation (2),
- et des moyens d'aspiration (34) pour aspirer, par l'intermédiaire de ce tube d'aspiration, un débit réglable des gaz présents dans cette chambre.

5. Cellule selon la revendication 4, caractérisée par le fait que ladite sortie (6) de la chambre de sublimation (2) est munie d'un tube de transfert (34) présentant une section de passage (35) supérieure à quatre fois celle (40) dudit passage de transfert étroit (38), une entrée (36) ouverte sur l'espace interne (3) de cette chambre, et une sortie formant ledit passage de transfert étroit (38), ladite entrée (32) du tube d'aspiration (30) étant située dans ce tube de transfert.

6. Cellule selon la revendication 3, caractérisée par le fait que d'une part ladite puissance thermique de sublimation est telle, d'autre part la sortie (28) du conduit d'amenée de gaz vecteur (26) dans la chambre de sublimation (2) et la sortie (6) de cette chambre sont disposées de telle façon que le gaz vecteur balaie l'espace interne (3) de cette chambre et y soit sensiblement saturé, au moins au voisinage de la sortie (6) de cette chambre, par lesdites molécules primaires.

7. Cellule selon la revendication 5, caractérisée par le fait qu'elle comporte trois pièces raccordées entre elles en série de manière amovible, à savoir :
- une pièce de base (42) constituant au moins un fond (44) et une paroi latérale (46) de la chambre de sublimation (2),
- une pièce intermédiaire (48) constituant au moins partiellement un couvercle (50) de la chambre de sublimation et le tube de transfert (34),
- et une pièce terminale (10) constituant au moins la tête de craquage,
- ledit passage de transfert étroit (38) étant formé par l'une au moins des pièces intermédiaire (48) et terminale (10).

8. Cellule selon la revendication 7, dans laquelle lesdites pièces de base (42) et intermédiaire (48) sont constituées de quartz et la pièce terminale (10) est constituée de nitrure de bore et présente des chicanes internes (52) pour thermaliser lesdites molécules primaires et secondaires.

## Claims

1. An effusion method for forming molecular beams, in which method primary molecules are formed by sublimation in a sublimation chamber (2), they are then transferred at a transfer flow-rate to a decomposition head (10) at a higher temperature, and they are transformed therein into secondary molecules that are lighter in weight to form molecular beams (16), the method being characterized by the fact that the transfer flow-rate is adjusted by adjusting an effective vector flow-rate which is the vector flow-rate of a vector gas inserted into the sublimation chamber.

2. A method according to claim 1, in which said primary and secondary molecules are respectively tetramers (P₄, As₄) and dimers (P₂, As₂) of phosphorus (P) or arsenic (As), said vector gas being hydrogen (H₂), argon (Ar) or nitrogen (N₂), said sublimation chamber and decomposition head respectively being brought to temperatures lying in the vicinity of 300°C and 900°C, said molecular beams being injected into an epitaxial growth chamber (18).

3. An effusion cell for forming molecular beams, the cell including:
a sublimation chamber (2) having an inside space (3) for containing a charge (4) of a chemical in the solid state, which chemical can constitute two species of gas molecules, one of which is constituted by primary molecules, and the other of which is constituted by secondary molecules which are lighter in weight than the primary molecules and which are to form a molecular beam having the desired mass flow-rate, the chamber having an outlet (6) to enable gas molecules in the chemical to leave the chamber;
sublimation heater means (8) for supplying a sublimation heating power so as to heat the chamber to a sublimation temperature causing said chemical to sublime in the form of said primary molecules with an average mass flow-rate of not less than said desired mass flow-rate, so that the primary molecules leave the chamber at an adjustable mass flow-rate that constitutes a transfer flow-rate;
a hollow decomposition head (10) having an inlet (12) for receiving said primary molecules leaving the sublimation chamber (2), and an outlet for enabling gas molecules to leave the head, towards an evacuated enclosure (18); and
decomposition heater means (20) for heating the decomposition head (10) to a decomposition temperature which is higher than said sublimation temperature, and which is chosen so as to form said secondary molecules from said primary molecules in the head, so that the secondary molecules leave the chamber by forming said molecular beam (16) with a mass flow-rate substantially equal to said transfer flow-rate;
the cell being characterized by the fact that it further includes:
a vector gas source (22) for supplying a vector gas suitable for entraining said primary molecules without reacting with the chemical;
a vector gas feed pipe (26) having an outlet (28) in said sublimation chamber (2) for inserting the vector gas therein at an inlet vector flow-rate; and
a narrow transfer passage (38) between the sublimation chamber (2) and said decomposition head (10) for maintaining a gas pressure that is higher in the chamber than in the head;
so that an effective vector flow-rate of said vector gas is constituted on the basis of the inlet vector flow-rate and passes through the transfer passage, and so that adjusting the effective vector flow-rate adjusts said transfer flow-rate.

4. A cell according to claim 3, characterized by the fact that it further includes:
a suction tube (30) having an inlet (32) in the sublimation chamber (2); and
suction means (34) for sucking out an adjustable flow-rate of the gases present in the chamber via the suction tube.

5. A cell according to claim 4, characterized by the fact that said outlet (6) of the sublimation chamber (2) is equipped with a transfer tube (34) having a flow section (35) larger than four times the flow section (40) of said narrow transfer passage (38), an inlet (36) which is open to the inside space (3) of the chamber, and an outlet forming the narrow transfer passage (38), said inlet (32) of the suction tube (30) being situated in the transfer tube.

6. A cell according to claim 3, characterized by the fact that firstly said sublimation heating power is chosen, and secondly the outlet (28) of the vector gas feed pipe (26) in the sublimation chamber (2) and the outlet (6) of the chamber are disposed in such a manner that the vector gas sweeps the inside space (3) of the chamber, and is substantially saturated therein by said primary molecules, at least in the vicinity of the outlet (6) of the chamber.

7. A cell according to claim 5, characterized by the fact that it comprises three portions removably interconnected in series, namely:
a base portion (42) constituting at least the bottom (44) and the sidewall (46) of the sublimation chamber (2);
an intermediate portion (48) at least partially constituting the cover (50) of the sublimation chamber and the transfer tube (34); and
an end portion (10) constituting at least the decomposition head;
said narrow transfer passage (38) being formed by at least one portion chosen from the intermediate portion (48) and the end portion (10).

8. A cell according to claim 7, in which said base portion (42) and said intermediate portion (48) are made of quartz, and the end portion (10) is made of boron nitride and has internal baffles (52) for thermalizing said primary molecules and said secondary molecules.

## Patentansprüche

1. Diffusionsverfahren für die Bildung von Molekularstrahlen, bei dem Primärmoleküle durch Sublimation in einer Sublimationskammer (2) erzeugt werden und dann mit einem Transferdurchsatz in einen Spaltkopf (10) transferiert werden, wo sie bei höherer Temperatur in leichtere Sekundärmoleküle umgewandelt werden, die den Molekularstrahl (16) bilden, dadurch gekennzeichnet, daß der Transferdurchsatz durch Regelung eines effektiven Trägergasdurchsatzes geregelt wird, der in die Sublimationskammer eingeführt wird.

2. Verfahren nach Anspruch 1, in dem die Primär- und Sekundärmoleküle vierwertiges bzw. zweiwertiges Phosphor oder Arsen sind, während das Trägergas von Wasserstoff (H₂), Argon (Ar) oder Stickstoff (N₂) gebildet wird, wobei die Sublimationskammer und der Spaltkopf auf Temperaturen in der Nähe von 300°C bzw. 900°C gebracht werden und die Molekularstrahlen in einen Raum (18) eingespeist werden, in dem ein epitaxiales Wachstum stattfindet.

3. Diffusionszelle zur Bildung von Molekularstrahlen, die aufweist:
- eine Sublimationskammer (2), in deren Innenraum (3) eine Menge (4) eines chemischen Stoffs im festen Zustand enthalten ist, der zwei gasförmige Molekültypen bilden kann, von denen einer ein Primärmolekül und das andere ein Sekundärmolekül ist, das leichter als das Primärmolekül ist und einen Molekularstrahl mit einem gewünschten Massendurchsatz bilden soll, wobei diese Kammer einen Ausgang (6) besitzt, durch den gasförmige Moleküle dieses Stoffs aus der Kammer austreten können,
- ein Sublimations-Heizmittel (8), das eine Sublimationswärmeleistung liefert, um diese Kammer auf eine Sublimationstemperatur zu bringen, bei der die Sublimation des chemischen Stoffs in der Form der Primärmoleküle mit einem Massendurchsatz mindestens gleich dem Mittelwert des gewünschten Massendurchsatzes erfolgt, so daß die Primärmoleküle aus der Kammer mit einem regelbaren Massendurchsatz austreten, der als Transferdurchsatz bezeichnet wird,
- einen hohlen Spaltkopf (10) mit einem Eingang (12), um die aus der Sublimationskammer (2) austretenden Primärmoleküle zu empfangen, und einem Ausgang, durch den gasförmige Moleküle diesen Kopf in Richtung auf einen Vakuumraum (18) verlassen können,
- und ein Spaltheizmittel (20), um den Spaltkopf (10) auf eine Spalttemperatur zu bringen, die höher als die Sublimationstemperatur ist und so gewählt wird, daS in diesen Kopf die Sekundärmoleküle aus den Primärmolekülen gebildet werden, so daß diese Sekundärmoleküle aus der Kammer austreten und dabei den Molekularstrom (16) mit einem Massendurchsatz bilden, der im wesentlichen dem Transferdurchsatz gleicht, dadurch gekennzeichnet, daß die Zelle außerdem aufweist:
- eine Quelle eines Trägergases (22), die ein geeignetes Trägergas liefert, um die Primärmoleküle mitzureißen, ohne mit dem chemischen Stoff zu reagieren,
- eine Zufuhrleitung (26) für Trägergas mit einem Ausgang (28), der in die Sublimationskammer mündet und über den dieses Gas mit einem Eingangsdurchsatz eingeführt wird,
- und einen engen Transferdurchlaß (38) zwischen dieser Sublimationskammer (2) und dem Spaltkopf (10), um einen höheren Gasdruck in dieser Kammer als im Kopf aufrechtzuerhalten, so daß ein effektiver Trägergasdurchsatz aus diesem Eingangsdurchsatz gebildet wird und den Transferdurchlaß durchströmt und eine Regelung dieses effektiven Trägergasdurchsatzes eine Regelung des Transferdurchsatzes bewirkt.

4. Zelle nach Anspruch 3, dadurch gekennzeichnet, daß sie weiter aufweist
- ein Saugrohr (30) mit einem Eingang (32) in die Sublimationskammer,
- und Saugmittel (34), um über dieses Saugrohr einen regelbaren Durchsatz der in dieser Kammer vorhandenen Gase anzusaugen.

5. Zelle nach Anspruch 4, dadurch gekennzeichnet, daß der Ausgang (6) der Sublimationskammer (2) ein Transferrohr (34') mit einem mehr als viermal größeren Durchlaßquerschnitt (35) als der Durchlaßquerschnitt (40) des engen Transferdurchlasses (38) aufweist, dessen Eingang (36) sich zum Innenraum (3) dieser Kammer öffnet und dessen Ausgang den engen Transferdurchlaß (38) bildet, wobei der Eingang (32) des Saugrohrs (30) in diesem Transferrohr liegt.

6. Zelle nach Anspruch 3, dadurch gekennzeichnet, daß einerseits die Wärmeleistung der Sublimationskammer so gewählt ist und andererseits der Ausgang (28) der Trägergaszufuhrleitung (26) zur Sublimationskammer (2) und der Ausgang (6) aus dieser Kammer so angeordnet sind, daß das Trägergas den Innenraum (3) dieser Kammer durchspült und dort im wesentlichen zumindest in der Nähe des Ausgangs (6) dieser Kammer mit den Primärmolekülen gesättigt wird.

7. Zelle nach Anspruch 5, dadurch gekennzeichnet, daß sie drei miteinander in Serie in lösbarer Form verbundene Bauteile enthält, nämlich:
- ein Basisbauteil (42), das mindestens einen Boden (44) und eine Seitenwand (46) der Sublimationskammer bildet,
- ein Zwischenbauteil (48), das mindestens teilweise einen Deckel (50) der Sublimationskammer und das Transferrohr (34) bildet,
- und ein endseitiges Bauteil (10), das mindestens den Spaltkopf bildet,
- wobei der enge Transferdurchlaß durch das Zwischenbauteil (48) oder das endseitige Bauteil (10) oder beide gebildet wird.

8. Zelle nach Anspruch 7, in der das Basisbauteil (42) und das Zwischenbauteil (48) aus Quarz bestehen und das endseitige Bauteil (10) aus Bornitrid, wobei letzteres innere Schikanen (52) aufweist, um die Primär- und Sekundärmoleküle zu thermalisieren.
